# EUROPEAN PATENT APPLICATION

(11) **EP 3 648 179 A1**
(43) Date of publication of application: **06.05.2020**
(21) Application number: 17916539.4
(22) Date of filing: 03.07.2017
(51) Int. Cl.: H01L 31/052

(54) **FRESNEL CONDENSER DEVICE AND CONDENSER-TYPE SOLAR ENERGY SYSTEM**

(71) Applicant: Bolymedia Holdings Co. Ltd., Santa Clara, California 95051 (US)
(72) Inventor: HU, Xiaoping, Shenzhen Guangdong 518055 (CN)
(74) Representative: Manitz Finsterwald Patent- und Rechtsanwaltspartnerschaft mbB
(86) International application number: PCT/CN2017/091414
(87) International publication number: WO 2019/006579

(57) **Abstract**

A Fresnel condenser device and a condenser-type solar energy system are provided, wherein the condenser device comprises first and second Fresnel lens layers (110, 130), each lens layer comprising at least one condenser-type Fresnel lens (111, 131); and a straight box-shaped light guiding layer (120), the first and second Fresnel lens layers (110, 130) being disposed respectively on two ends thereof, and the straight box-shaped light guiding layer (120) is configured to direct a light (LL) from the first Fresnel lens layer (110) down to the second Fresnel lens layer (130). By utilizing two Fresnel lens layers (110, 130) to respectively perform light convergence and using the straight box-shaped light guiding layer (120) therebetween to help direct the light from an upper layer to a lower layer, the condenser device can not only adapt to a wide range of incident angles, but also obtain a large light convergence ratio at a low height, avoiding dependence on sun tracking systems.

## Description

### TECHNICAL FIELD

The present disclosure relates to optical elements and clean energy, and in particular to Fresnel light-concentrating apparatus containing a Fresnel lens and their application in concentrating solar systems.

### BACKGROUND

With increasing focus on environmental protection, solar energy systems have been growing in popularity. Among them, concentrating solar systems are receiving attention increasingly on account of capable of enhancing the utilization efficiency of solar energy.

Fresnel lenses are often used as concentrating-type optical elements in available light-concentrating solar systems. However, by employing an optical structure in which a Fresnel lens is used to directly focus on a light energy utilizing device, the conventional light-concentrating system tends to be less adaptable to the incident angle of sunlight, making an available solar system limited in two aspects, that is, it needs to be used in conjunction with a sun tracking device, and its concentration ratio is restrained.

In addition, the concentrating device of the available solar system also has a shortage in terms of height, because the height of the light-concentrating device usually increases as the concentration ratio increases.

Therefore, it is necessary to study a Fresnel light-concentrating apparatus that has better adaptability to the incident angle, and can increase the concentration ratio or reduce the height of the system.

### SUMMARY

According to one aspect of the present disclosure, a Fresnel light-concentrating device provided may include a first and a second Fresnel lens layers and a straight box-shaped light guiding layer. Each lens layer may include at least one light-concentrating Fresnel lens. The straight box-shaped light guiding layer has a straight-box shape, the first and second Fresnel lens layers are arranged respectively on two ends of the straight-box shape, and the straight box-shaped light guiding layer is configured to direct a light from the first Fresnel lens layer down to the second Fresnel lens layer.

According to another aspect of the present disclosure, a light-concentrating solar system provided may include the Fresnel light-concentrating apparatus of the present disclosure and at least one light energy utilizing device. The light energy utilizing device has a light-receiving surface arranged on an optical path behind the Fresnel light-concentrating apparatus.

According to the Fresnel light-concentrating apparatus, by means of utilizing two Fresnel lens layers to respectively perform light convergence and using the straight box-shaped light guiding layer therebetween to help direct the light from an upper layer to a lower layer, the light-concentrating apparatus can not only adapt to a wide range of incident angles, but also obtain a large light convergence ratio at a low height, avoiding dependence on sun tracking systems.

Specific examples according to the present disclosure are described in detail below with reference to the accompanying drawings. As used herein, terms that indicate a position, such as "upper", "lower", "top", "bottom" and the like, only refer to relative positional relationships, having no absolute meanings. The serial numbers or sequence numbers used herein, such as "first", "second", etc., are merely illustrative without any restrictive meanings.

### BRIEF DESCRIPTION OF THE DRAWINGS

FIG. 1 is a schematic diagram of a Fresnel light-concentrating apparatus according to Embodiment 1;
FIG. 2 is a schematic diagram of a Fresnel light-concentrating apparatus according to Embodiment 2;
FIG. 3 is a schematic diagram of a concentrating solar system according to Embodiment 3; and
FIG. 4 is a schematic diagram of a concentrating solar system according to Embodiment 4.

### DETAILED DESCRIPTION

### Embodiment 1

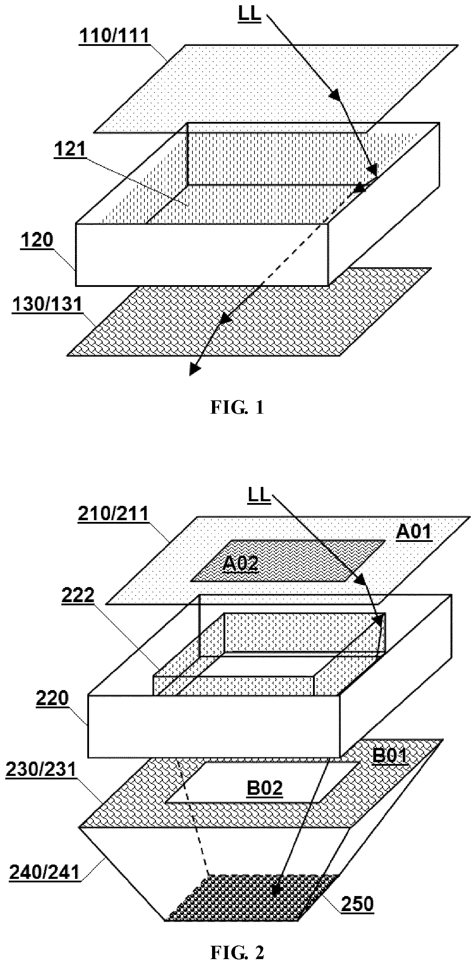

Referring to FIG. 1, a Fresnel light-concentrating apparatus according to one embodiment of the present disclosure is schematically shown in structure after being longitudinally decomposed. The Fresnel light-concentrating apparatus may include a first Fresnel lens layer 110, a straight box-shaped light guiding layer 120 and a second Fresnel lens layer 130.

A Fresnel lens is used as an optical element in the Fresnel lens layer in the present disclosure, and each lens layer may include at least one light-concentrating Fresnel lens. The Fresnel lens is a thin one with a number of advantages including being thin and light and convenient for batch production. A "concentrating" (or "astigmatic") Fresnel lens herein refers to a Fresnel lens that functionally condenses light toward the optical center of the lens (or diffuses out of the optical center), and its tooth surface usually comes from a convex lens surface (or a concave lens surface). A "linear" Fresnel lens herein including a linear astigmatic Fresnel lens and a linear light-concentrating Fresnel lens means that the focus center of the lens is a line instead of being concentrated at one point. For example, the tooth surface of a linear Fresnel lens may be originated from a concave (or convex) cylindrical surface, or a concave (or convex) polynomial cylindrical surface. The Fresnel lens may be a single-sided Fresnel lens with one toothed surface and one plane, or a double-sided Fresnel lens with both toothed surfaces. Each tooth surface of each Fresnel lens can be a simple lens surface containing only one Fresnel unit, or a composite lens surface composed of multiple Fresnel units which thereby forming a composite Fresnel lens .

The first and second Fresnel lens layers in this embodiment are formed by a single concentrating simple Fresnel lens 111, 131, respectively as an uncomplicated case. In other embodiments, the first and second Fresnel lens layers may also be a more intricate structure, such as having multiple Fresnel lenses, or having a double-sided Fresnel lens, or a composite Fresnel lens. lens. Preferably, a multi-focus Fresnel lens may be used in at least one lens layer. The so-called multi-focus Fresnel lens is divided into different regions according to the distance from its central optical axis, wherein the region farther from the central optical axis has a shorter focal length, and the region closer to the central optical axis has a longer focal length. The so-called longer focal length may include a case where the focal length is infinite, in which case, the corresponding region is, for example, a hollowed-out area, or is formed of a flat transparent material.

In an optional embodiment, at least one light-concentrating Fresnel lens of the first or second Fresnel lens layer may employ a linear light-concentrating Fresnel lens, wherein the focusing centerline of each linear lens is substantially perpendicular to the optical axis (or the central axis, that is, the direction in which the sunlight is incident vertically) of the entire concentrating device. Preferably, the focusing centerlines of the linear light-concentrating Fresnel lenses of different layers are perpendicular to each other, so that two linear Fresnel lens layers form a two-dimensional Fresnel lens (i.e., which has a single central optical axis and focus) . Such structure can help to achieve a uniform light intensity distribution in the focal plane, or to achieve complex optical designs through easy-to-process lens combinations.

The appearance of the straight box-shaped light guiding layer 120 may be a straight-line tube shape. The first and second Fresnel lens layers are respectively arranged at both ends of the straight box-shaped light guiding layer. The straight box-shaped light guiding layer is used to direct a light from the first Fresnel lens layer down to the second Fresnel lens layer. The tube wall of the straight box-shaped light guiding layer is perpendicular to the two lens layers (that is, substantially the same as the direction of the optical axis of the entire concentrating device). It may be transparent, or is provided with a reflective mirror surface on at least part of the inner wall.

Various optical designs can be used to guide light for the straight box-shaped light guiding layer, for example: guiding the light with the reflective mirror surface on the inner wall; or deflecting incident light downwards assisted by a high-pressure gas or optical gas (which refers to a gas with a refractive index greater than 1 at a standard atmospheric pressure) filled in a closed first space formed by the tube wall of the straight box-shaped light guiding layer and the first and second Fresnel lens layers; or providing other optical elements that assist light deflection in the inner space of the straight box-shaped light guide layer.

In this embodiment, used is a structure in which the inner wall of the tube is a reflective mirror and an optical gas 121 is filled in the closed first space. The incident light LL is guided to the bottom lens layer through the convergence on the top lens layer and the deflection of the straight box-shaped light guiding layer

In this embodiment, the cross-section of the straight box-shaped light guiding layer is square; while in other embodiments, different cross-sectional shapes may be adopted. In order to facilitate the close arrangement or integration of multiple light-concentrating devices, the cross-sectional shape of the straight tube may be various regular and easy-to-manufacture shapes, for example, it can be selected from the group consisting of: quadrilateral, hexagonal, circular, etc..

In this embodiment, the Fresnel light concentrating device can achieve a high light concentration ratio and a relatively low height. It can be combined with any light or electromagnetic energy receiving device to form a light concentrating light or electromagnetic energy receiving system, for example, to use in a concentrating solar system.

### Embodiment 2

Referring to FIG. 2, a Fresnel light-concentrating apparatus according to another embodiment of the present disclosure is schematically shown in structure after being longitudinally decomposed. The Fresnel light-concentrating apparatus may include a first Fresnel lens layer 210, a straight box-shaped light guiding layer 220, a second Fresnel lens layer 230 and a tapered light guiding layer 240.

The basic structural relationship between the two lens layers and the straight box-shaped light guiding layer in this embodiment is similar to that in Embodiment 1, but there are some main differences as follow:
1. The first Fresnel lens layer 210 preferably uses a multi-focus Fresnel lens 211, the surface of which is divided into two concentric regions of similar shape, wherein the region further away from the central optical axis (i.e. peripheral region A01) has a shorter focal length and the region closer to the central optical axis (central region A02) has a longer focal length;
2. The second Fresnel lens layer 230 preferably uses a multi-focus Fresnel lens 231, which has a Fresnel lens surface only in the peripheral region B01, and the central region B02 is hollowed out; and
3. The straight box-shaped light guiding layer 220 also includes a light scattering tube 222 having a tube wall formed by a linear astigmatic Fresnel lens, wherein the length extension direction of the light scattering tube is consistent with the straight box-shaped light guiding layer, and the light scattering tube is arranged in an internal space of the straight box-shaped light guiding layer. The focusing centerline of each linear astigmatic Fresnel lens is perpendicular to the length extension direction of the light scattering tube.

The light scattering tube 222 can scatter the incident light to the lower end of the straight tube to enhance the deflection of the incident light off the optical axis by the straight box-shaped light guiding layer, which is beneficial to subsequent optical elements to finally guide the light LL to a light energy utilizing device. The cross-sectional shape of the light scattering tube may be the same as or different from the cross-sectional shape of the tube wall of the straight box-shaped light guiding layer surrounding the outside. In this embodiment, a box shape is adopted.

The tapered light guiding layer 240 arranged below the second Fresnel lens layer 230 may include at least one reflective tapered light guiding tube 241. The tapered light guiding tube having a larger top opening and a smaller bottom opening may be provided entirely or at least partially a reflective mirror on its inner wall, and the light converging through the second Fresnel lens layer may be incident from the top of the tapered light guiding tube and be guided to the bottom. The cross-sectional shape of the tapered light guiding tube may be a quadrangle, a hexagon, a circle, or the like.

The bottom of the tapered light guiding tube 241 may be closed so as to provide a light energy utilizing device thereon, thereby forming a concentrating solar system, or a light energy utilizing device may be employed to enclose the bottom of the tapered light guiding tube. After the bottom of the tapered light guiding tube is closed, its tube wall and the second Fresnel lens layer together form a closed second space, which can be further filled with high-pressure gas or optical gas to increase the light concentration ratio.

In a simple case of a concentrating solar system, a light energy utilizing device that receives light on one side, such as a photovoltaic panel 250 that receives light on one side, may be arranged at the bottom of the tapered light guiding tube, and its light receiving surface faces toward the top of the tapered light guiding tube. The "photovoltaic panel" referred to in the present disclosure may generally refer to various types of photovoltaic conversion devices, such as photovoltaic panels, photovoltaic films, quantum dot photovoltaic materials and the like which are made of various materials.

### Embodiment 3

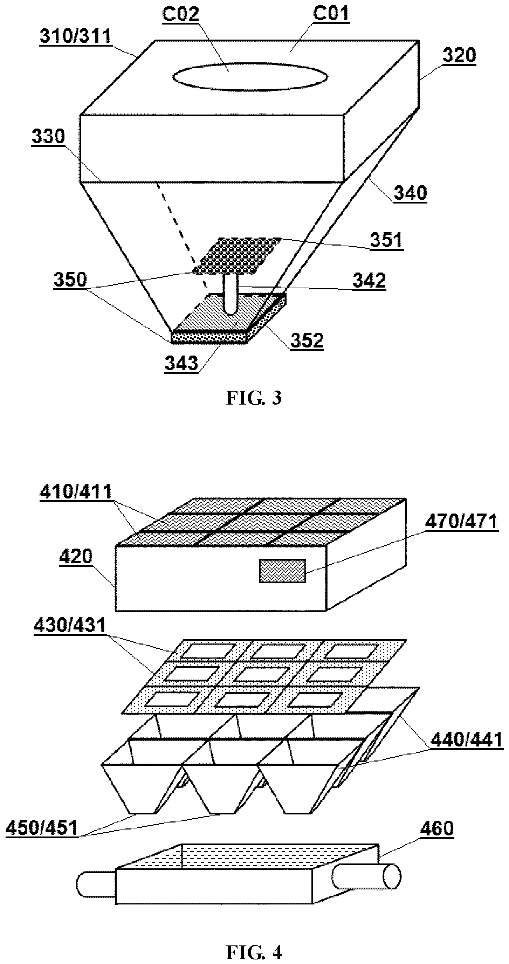

Referring to FIG. 3, a concentrating solar system according to an embodiment of the present disclosure is schematically shown in structure after assembly. The concentrating solar system may include a first Fresnel lens layer 310, a straight box-shaped light guiding layer 320, a second Fresnel lens layer 330, a tapered light guiding layer 340 and a light energy utilizing device 350.

The basic structural relationship between the two lens layers and the two light guiding layers in this embodiment is similar to that in Embodiment 2, and there are some main differences as follow:
The first Fresnel lens layer 310 uses a multi-focus Fresnel lens 311, the surface of which is divided into two regions with different shapes, wherein the central region C02 is circular, and the peripheral region C01 is square. This reflects the flexibility of the structure according to the present disclosure in light path design and shape design.

In addition, the light energy utilizing device 350 in this embodiment is composite, that is, it includes a thermoelectric conversion device 352 in addition to a photovoltaic panel 351. The thermoelectric conversion device may be arranged on a heat conduction path for the photovoltaic panel to dissipate heat outward, so as to further convert thermal energy into electrical energy during the process of dissipating heat from the photovoltaic panel. The thermoelectric conversion device may use, for example, a semiconductor device having a thermo-electric effect.

In this embodiment, the photovoltaic panel 351 and the thermoelectric conversion device 352 are separately provided, wherein the photovoltaic panel 351 is disposed in a tapered light guiding tube and is fixed on the tapered light guiding tube by a thermally conductive support 342. In this case, the bottom of the tapered light guiding tube can be closed by a reflecting mirror surface 343. The thermoelectric conversion device 352 may be thermally attached to the back side of the bottom of the tapered light guiding tube. In this case, the photovoltaic panel 351 may preferably be a photovoltaic panel that receives light on both sides to improve light energy utilization.

In other embodiments, for example, when the photovoltaic panel 250 with a single light-receiving surface is disposed on the bottom of the tapered light guiding tube as shown in FIG. 2, the thermoelectric conversion device may also be thermally attached to the back side of the photovoltaic panel with a single light-receiving surface, so that the composite light energy utilizing device is formed as a whole.

### Embodiment 4

Referring to FIG. 4, a concentrating solar system according to another embodiment of the present disclosure is schematically shown in structure after being longitudinally decomposed. The concentrating solar system may include a first Fresnel lens layer 410, a straight box-shaped light guiding layer 420, a second Fresnel lens layer 430, a tapered light guiding layer 440, a light energy utilizing device 450 and a bottom tray 460.

This embodiment shows an integrated implementation of the system according to the present disclosure, in order to facilitate production and reduce costs. The Fresnel light-concentrating apparatus according to the present disclosure may be individually manufactured and then integrated together; or each layer may be composed of multiple units, and each layer is integrated separately and then combined together as a whole; or some layers use an integrated multi-unit structure while other layers are structured as a single element as a whole.

As an example, this embodiment shows a mixed one, wherein:
the first Fresnel lens layer 410 may include a plurality of light-concentrating Fresnel lenses 411 arranged in an array, each lens 411 may be a simple Fresnel lens or a composite Fresnel lens, and the entire lens layer 410 may be formed by combination of a plurality of units, or may be an integral whole, and each lens 411 is divided by a pattern of its tooth surface;
the second Fresnel lens layer 430 may include a plurality of light-concentrating Fresnel lenses 431 arranged in an array, each of which is a multi-focus Fresnel lens with a hollow in the central region;
the straight box-shaped light guiding layer 420 may be formed by a plurality of straight box-shaped light guiding tubes (not shown) arranged in an array, each straight box-shaped light guiding tube may correspond to a pair of lenses 411, 431, or may be a large light guiding straight box-shaped tube as a whole; and
the tapered light guiding layer 440 may include a plurality of tapered light guiding tubes 441 arranged in an array, accordingly, the light energy utilizing device 450 may include a plurality of photovoltaic panels 451 which are respectively arranged at the bottom of the tapered light guiding tube 441.

In order to improve the heat dissipation speed of the light energy utilizing device and take advantage of the dissipated heat at the same time, a bottom tray 460 may also be preferably included, which is arranged below the tapered light guiding layer 440 and is enclosed with the tapered light guiding layer, to form a closed third space in this embodiment. The third space can contain a working medium, which is thermally connected to the photovoltaic panel 451. The working medium may preferably be a substance having a large heat capacity, which may be a solid or a fluid. The heat absorbed by the working medium may be provided to external use through further heat conduction or through the circulation of the working medium. The fluid working medium used can be selected from: water, oil, refrigerant, compressed gas, and the like. In this case, an inlet and an outlet for the inflow and outflow of the working medium may be further provided on the bottom tray. The circulation system of liquid working medium can be either open or closed, which can be determined according to the type of the working medium and the desired form of heat energy utilization. Preferably, a thermoelectric conversion device (not shown) may be further provided on the heat conduction path between the photovoltaic conversion device and the working medium. For example, the thermoelectric conversion device may be disposed on the back of the bottom of the tapered light guiding tube 441 and soaked in the working medium.

As a preferred implementation manner, this embodiment may further include a piezoelectric vibrator 470 having a piezoelectric vibrating piece 471 and a driving circuit (not shown in the figures). The piezoelectric vibrating piece 471 is mechanically connected to the first Fresnel lens layer 410 (for example, fixed to the outside of the straight box-shaped light guiding layer 420) to drive it to vibrate. The vibrator can be used, for example, for automatic cleaning of a light-receiving surface of a light-concentrating device, or for removing snow and ice. In other embodiments, the piezoelectric vibrating piece may be fixed at other positions, which is not limited in the present disclosure.

The principle and implementation manners present disclosure have been described above with reference to the specific examples, which are merely provided for the purpose of understanding the present disclosure and are not intended to limit the present disclosure. It will be possible for those skilled in the art to make variations based on the principle of the present disclosure.

## Claims

1. A Fresnel light-concentrating apparatus, comprising:
a first Fresnel lens layer,
a second Fresnel lens layer,
each lens layer comprising at least one light-concentrating Fresnel lens, and
a straight box-shaped light guiding layer having a straight-box shape, the first and second Fresnel lens layers being arranged respectively on two ends of the straight-box shape, and the straight box-shaped light guiding layer being configured to direct a light from the first Fresnel lens layer down to the second Fresnel lens layer.

2. The apparatus according to claim 1, wherein
the inner wall of the straight box-shaped light guiding layer is a reflective mirror surface; or,
the wall of the straight box-shaped light guiding layer and the first and second Fresnel lens layers form a closed first space filled with a high-pressure gas or optical gas; or,
the straight box-shaped light guiding layer further comprises a light scattering tube having a tube wall formed by a linear astigmatic Fresnel lens, the light scattering tube is consistent with the straight box-shaped light guiding layer in the length extension direction and is arranged in an internal space of the straight box-shaped light guiding layer, and the focal centerline of the linear astigmatic Fresnel lens is perpendicular to the length extension direction.

3. The apparatus according to claim 1 or 2, wherein at least one light-concentrating Fresnel lens of the first or second Fresnel lens layer is a multi-focus Fresnel lens, or a double-sided Fresnel lens or a composite Fresnel lens, and
the multi-focus Fresnel lens is divided into different regions according to the distance from its central optical axis, wherein the region farther from the central optical axis has a shorter focal length, and the region closer to the central optical axis has a longer focal length which includes a case where the focal length is infinite.

4. The apparatus according to any one of claims 1 to 3, wherein at least one light-concentrating Fresnel lens of the first or second Fresnel lens layer is a linear light-concentrating Fresnel lens, and the focusing centerline of each linear light-concentrating Fresnel lens on different layers is perpendicular to each other.

5. The apparatus according to any one of claims 1 to 4, comprising at least one of the following characteristics:
the first Fresnel lens comprising a plurality of light-concentrating Fresnel lenses arranged in an array;
the second Fresnel lens comprising a plurality of light-concentrating Fresnel lenses arranged in an array; and
the straight box-shaped light guiding layer comprising a plurality of straight box-shaped light guiding tubes arranged in an array, the cross-sectional shape of the straight box-shaped light guiding tube selected from a group consisting of quadrilateral, hexagonal and circular.

6. The apparatus according to any one of claims 1 to 5, further comprising
a tapered light guiding layer arranged below the second Fresnel lens layer, wherein the tapered light guiding layer includes at least one reflective tapered light guiding tube having at least partially a reflective mirror on its inner wall, a larger opening on the top and a smaller opening on the bottom, and the light converging through the second Fresnel lens layer is incident from the top of the tapered light guiding tube.

7. The apparatus according to claim 6, wherein the bottom of the tapered light guiding tube is closed, forming a closed second space with the second Fresnel lens layer by its tube wall.

8. The apparatus according to any one of claims 1 to 7, further comprising
a piezoelectric vibrator having a piezoelectric vibrating piece and a driving circuit, the piezoelectric vibrating piece being mechanically connected to the first Fresnel lens layer.

9. A light-concentrating solar system, comprising:
the Fresnel light-concentrating apparatus according to any one of claims 1 to 8; and
at least one light energy utilizing device having a light-receiving surface arranged on an optical path behind the Fresnel light-concentrating apparatus.

10. The system according to claim 9, wherein
the system comprises the Fresnel light-concentrating apparatus according to any one of claims 6 to 8; and
the light energy utilizing device is arranged at the bottom of the tapered light guiding tube or in the tapered light guiding tube, and the light energy utilizing device includes a photovoltaic conversion device.

11. The system according to claim 10, wherein
the photovoltaic conversion device is a photovoltaic panel having a single light-receiving surface, which is arranged on the bottom of the tapered light guiding tube and the light-receiving surface faces toward the top of the tapered light guiding tube, or,
the photovoltaic conversion device is a photovoltaic panel having double light-receiving surfaces, which is arranged in the tapered light guiding tube and fixed onto the tapered light guiding tube by a thermally conductive support, and the bottom of the tapered light guiding tube is closed by a reflective mirror.

12. The system according to claim 10 or 11, further comprising
a bottom tray arranged below the tapered light guiding layer, forming a closed third space with the tapered light guiding layer, wherein the third space contains a working medium thermally connected to the photovoltaic conversion device, and the working medium is selected from water, oil, refrigerant and compressed gas.

13. The system according to any one of claims 10 to 12, wherein the light energy utilizing device further comprises a thermoelectric conversion device arranged on a heat conduction path for the photovoltaic conversion device to dissipate heat.
